# EUROPÄISCHE PATENTANMELDUNG

(11) **EP 1 411 539 A2**
(43) Veröffentlichungstag der Anmeldung: **21.04.2004**
(21) Anmeldenummer: 03021701.2
(22) Anmeldetag: 25.09.2003
(51) Int. Cl.: H01J 37/32

(54) **Einrichtung zur Erzeugung von Plasmen durch Hochfrequenzentladungen**

(30) Priorität: 14.10.2002 DE 10247888
(71) Anmelder: Fraunhofer-Gesellschaft zur Förderung der angewandten Forschung e.V., 80686 München (DE)
(72) Erfinder: Rank, Rolf, Dr., 01127 Dresden (DE); Morgner, Henry, Dr., 01257 Dresden (DE); Schiller, Nicolas, Dr., 01833 Stolpen OT Helmsdorf (DE); Weiske, Dieter, 01239 Dresden (DE); Schmidt, Jörg, 01277 Dresden (DE)

(57) **Zusammenfassung**

Die Erfindung betrifft eine Einrichtung zur Erzeugung von Plasmen durch Hochfrequenzentladungen für die Plasma- und Ionenbehandlung oder zur Abscheidung von Schichten durch Plasmapolymerisation auf flache platten- oder bandförmige Materialien oder anders geformte Substrate in Vakuumanlagen mit Hilfe eines mit Hochfrequenz gespeisten Plasmas, enthaltend mindestens zwei Elektroden, zwischen denen eine Plasmaentladung unterhalten werden kann, wobei eine Elektrode als Hohlelektrode 1 ausgeführt ist, eine geerdete ebene oder gekrümmte Fläche eine Gegenelektrode 16 bildet und die der Plasmaentladung abgewandte Seite der Hohlelektrode 1 von einer Abschirmelektrode 3 umschlossen ist, wobei der Raum zwischen Hohlelektrode 1 und Abschirmelektrode 3 vom Vakuum druckentkoppelt ausgeführt ist und in diesem Raum ein gegenüber dem Vakuum erhöhter Druck eingestellt werden kann.

## Beschreibung

Das Patent betrifft eine Einrichtung zur Erzeugung von Plasmen durch Hochfrequenzentladungen für die Plasma- und Ionen behandlung oder zur Abscheidung von Schichten durch Plasmapolymerisation auf flache platten- oder bandförmige Materialien oder anders geformte Substrate in Vakuumanlagen. Das Plasma wird durch Einspeisung von Hochfrequenz erzeugt, wobei vorzugsweise auf die verbreitet genutzte Frequenz von 13,56 MHz zurückgegriffen wird.

Es ist allgemein bekannt, dass hochfrequenzbetriebene Entladungseinrichtungen mit Elektrodenflächen ungleicher Größe und Form zur Erzeugung von Plasmen und zur Extraktion von höherenergetischen Ionen in Vakuumbeschichtungsprozessen verwendet werden (B. Chapman, Glow Discharge Processes - Sputtering And Plasma Etching, Chapter 5, p. 156 ff., John Wiley & Sons, New York 1980; M. Geisler, R.Kukla, J. Bartella, G. Hoffmann, R. Ludwig, D. Wagner, Large Scale RF-Plasma Tool for Ion Assisted Pre-Treatment and Deposition, Proceedings of the Fourteenth International Conference on Vacuum Web Coating; Reno, NV; October 25-27, 2000; pp. 119-128).

Beispielsweise ist eine Einrichtung zur Plasmabehandlung von Substraten beschrieben, bei der eine Hohlelektrode gegenüber einer ebenen, als Gegenelektrode wirkenden Fläche angeordnet ist (DE 36 06 959 A1 ). Derartige Anordnungen sind auf der Rückseite der Hohlelektrode mit einer Abschirmelektrode versehen, um elektromagnetische Abstrahlungen zu vermeiden. Eine derartige Abschirmelektrode ist oftmals aus zulassungstechnischen Gründen unumgänglich. Der Zwischenraum zwischen der Hohlelektrode und der umgebenden Abschirmelektrode ist über einen umlaufenden Spalt mit dem Prozessvakuum verbunden. Der Spalt sowie der Zwischenraum sind so dimensioniert, dass sie als Dunkelraumabschirmung wirken und dürfen einen bestimmten Abstand im Bereich von 5 mm bis 15 mm nicht überschreiten, um die Zündung von unerwünschten Entladungen zwischen der Hohlelektrode und der Abschirmelektrode zu vermeiden.

Es sind weiterhin Einrichtungen bekannt, die eine geteilte Hohlelektrode aufweisen (DE 40 39 930 A1). Der enge Abstand zur umhüllenden Abschirmelektode ist hier ebenfalls erforderlich.
Die elektrische Kapazität, die sich zwischen der Hohlelektrode und der Abschirmelektrode ausbildet, verhält sich proportional zur Fläche der Elektroden und umgekehrt proportional zum Abstand (Spaltbreite) der Elektroden. Diese Kapazität ist elektrisch parallel zur Plasmaentladung geschaltet und bildet einen kapazitiven Nebenschluss, der auch als Streukapazität bezeichnet wird. Der maximale Abstand zwischen der Hohlelektrode und der sie umgebenden Dunkelraumabschirmung ist physikalisch begründet und sollte im Vakuum bei gebräuchlichen Druckbereichen für Niederdruckentladungen 10 mm nicht überschreiten. Damit ist die Streukapazität der Anordnung von Hohlelektrode und Dunkelraumabschirmung durch eine weitere Vergrößerung des Abstandes nicht zu reduzieren.

Insbesondere mit der Aufskalierung derartiger Einrichtungen zur Behandlung oder Beschichtung großflächiger Substrate wächst diese Kapazität durch die erforderlichen großen Elektrodenflächen. Für größere Einrichtungen wird damit ein hoher kapazitiver Blindstrom generiert, dem mit hohem technischem Aufwand, insbesondere durch ein Hochfrequenz-Anpassnetzwerk, begegnet werden muss. Bei weiterer Vergrößerung der Einrichtung ist eine wirtschaftliche Gestaltung des Hochfrequenz-Anpassnetzwerks (Matchbox) und der Hochfrequenz-Zuleitungen oft nicht mehr möglich.

Es ist weiterhin bekannt, Magnetanordnungen zur Plasmabeeinflussung in der Nähe der Elektrodenanordnung zu platzieren, um die Wirkung des Plasmas zu erhöhen (DE 41 09 619 C1). Diese müssen aus konstruktiven Gründen häufig im Prozessraum untergebracht werden. Während des Betriebes in Bandbeschichtungsanlagen, sei es als Ätz- oder Vorbehandlungsquelle oder (bei Einlass geeigneter Reaktivgase) als Beschichtungsquelle, muss von einer Kontamination der Innenfläche der Hohlelektrode durch Rückstäubung (Kondensation von abgeätztem Material) oder Beschichtung ausgegangen werden. Insbesondere in industriellen Anlagen mit hohem Materialdurchsatz erscheint deshalb der Einbau der Magnete im Prozessraum unvorteilhaft, vor allem unter dem Gesichtspunkt einer effektiven Wartung und Reinigung und damit verbunden der Standzeit einer Hochfrequenz-Plasmaquelle.

Die Erfindung hat die Aufgabe, die Nachteile des Standes der Technik zu vermeiden und eine Einrichtung zu schaffen, die sich durch eine gegenüber gebräuchlichen Einrichtungen verringerte Streukapazität auszeichnet.

Erfindungsgemäß wird die Aufgabe nach den Merkmalen des Patentanspruches 1 gelöst. Weitere vorteilhafte Ausgestaltungen sind in den Ansprüchen 2 bis 12 beschrieben.

Die erfindungsgemäße Lösung basiert im Wesentlichen auf der Schaffung eines unter erhöhtem Druck stehenden, in der Regel belüfteten Zwischenraumes zwischen einer Hohlelektrode und einer sie umgebenden Abschirmelektrode (im Folgenden auch als Gehäuse bezeichnet). Die Wirkung der Abschirmelektrode wird dadurch kaum beeinflusst. Durch den erhöhten Druck wird jedoch die kritische Zündspannung, die zum Aufbau unerwünschter Entladungen zwischen Hohlelektrode und Abschirmelektrode erforderlich wäre, drastisch erhöht. Der Abstand zwischen diesen kann nahezu beliebig groß gestaltet werden. Mit wachsendem Abstand reduziert sich die Streukapazität in umgekehrter Proportionalität zum Abstand.
Erfindungsgemäß lässt sich dieses Prinzip in jeder Einrichtung zur Plasma- und lonenbehandlung oder zur Abscheidung von Schichten durch Plasmapolymerisation auf flache platten- oder bandförmige Materialien oder anders geformte Substrate in Vakuumanlagen mit Hilfe eines mit Hochfrequenz gespeisten Plasmas mit mindestens zwei Elektroden, zwischen denen eine Plasmaentladung unterhalten werden kann, wobei eine Elektrode als Hohlelektrode ausgeführt ist, eine geerdete ebene oder gekrümmte Fläche eine Gegenelektrode bildet und die der Plasmaentladung abgewandte Seite der Hohlelektrode von einer Abschirmelektrode umschlossen ist, verwirklichen, wenn der Raum zwischen Hohlelektrode und Abschirmelektrode vom Vakuum druckentkoppelt ausgeführt ist und in diesem Raum ein gegenüber dem Vakuum erhöhter Druck eingestellt werden kann. Besonders vorteilhaft ist es, diesen Raum vollständig gegenüber dem Vakuum abzudichten. Besonders einfach ist es, diesen auf Normaldruck zu halten, entweder durch einmalige Befüllung oder durch eine Verbindung zur die Anlage umgebenden Atmosphäre. Die Befüllung kann zu technologischen Zwecken mit anderen Gasen oder Gasgemischen erfolgen.
Die zur Aufrechterhaltung einer Plasmaentladung erforderliche Gegenelektrode befindet sich vorteilhafterweise dicht vor der Hohlelektrode und bildet zum Teil eine Begrenzung des plasmaerfüllten Raumes im Inneren der Hohlelektrode. Es ist besonders vorteilhaft, wenn das zu behandelnde oder zu beschichtende Substrat der Form der Gegenelektrode angepasst ist. Dadurch kann das Substrat sehr dicht an der Gegenelektrode vorbeigeführt werden, was für eine gute Wirksamkeit des eingesetzten Plasmas sorgt. Es kann weiterhin von Vorteil sein, das Substrat direkt auf der Gegenelektrode aufliegen zu lassen oder das Substrat, sofern es elektrisch leitfähig bzw. mit einer leitfähigen Beschichtung versehen ist, selbst als Gegenelektrode zu beschalten und an der Öffnung der Hohlelektrode vorbeizuführen.

Es ist weiterhin vorteilhaft, magnetfelderzeugende Einrichtungen, deren magnetisches Feld in das Plasma eingreift und zu einer magnetischen Verstärkung des Plasmas, zur Beeinflussung der Verteilung des Plasmas oder zu einer Reduzierung der Plasmaimpedanz führt, zu benutzen. Hierfür bietet die erfindungsgemäße Einrichtung gute Möglichkeiten, insbesondere wenn die magnetfelderzeugenden Einrichtungen außerhalb der Entladungsund Beschichtungszone in sauberer Umgebung platziert werden. Besonders vorteilhaft ist es, diese magnetfelderzeugenden Einrichtungen im druckentkoppelten Raum zwischen Hohlelektrode und Abschirmelektrode und/oder auf der der Plasmaentladung abgewandten Seite der Gegenelektrode anzubringen. Für viele Anwendungen genügt es, die magnetfelderzeugenden Einrichtungen aus Permanentmagneten aufzubauen. Falls einstellbare Magnetfelder benötigt werden, sind Magnetspulen mit einstellbarem Spulenstrom als Bestandteile der magnetfelderzeugenden Einrichtungen besonders vorteilhaft. Durch die geringe Beaufschlagung in dieser geschützten Einbauposition ist eine zusätzliche Kühlung der Magnete meist nicht erforderlich, was einen weiteren Vorteil der erfindungsgemäßen Lösung darstellt. Für viele Anwendungen ist es ausreichend, wenn die magnetfelderzeugenden Einrichtungen so dimensioniert sind, dass Flussdichten von 0 bis 50 mT erzeugt werden können.
Die hochfrequente Speisung der Hohlelektrode erfolgt üblicherweise von einem Hochfrequenz-Generator über einen oder mehrere konventionelle Koaxialleiter. Hierzu ist ein aktives oder passives Anpassnetzwerk erforderlich, das ebenfalls mit Vorteil im druckentkoppelten Raum zwischen Hohlelektrode und Abschirmelektrode installiert werden kann. Geringe Leitungslängen und die unmittelbare Nähe des Anpassnetzwerkes zum Ort der Energieeinkopplung sind Vorteile derartiger Ausführungsformen. Durch entsprechende Ausführung der Koaxialleiter und der Komponenten des Anpassnetzwerkes lässt sich in der erfindungsgemäßen Bauform auf besonders einfache Weise eine Einkopplung der Energie realisieren, die an mehr als einem Punkt auf der Hohlelektrode erfolgt. Auf ähnliche Weise lässt sich problemlos eine Wasserkühlung der Hohlelektrode realisieren, sofern dies aus technologischen Gründen erforderlich wird.
Die Realisierung des druckentkoppelten Zwischenraumes wird vorteilhafterweise erreicht durch das Verwenden eines Isolators, welcher den Umfang der Hohlelektrode umspannt. Dieser Isolator ist zugleich die Dichtung zwischen Vakuum und Normaldruck im Zwischenraum. Um zu gewährleisten, dass der Isolator durch den einseitig herrschenden Luftdruck nicht verschoben werden kann, wird er passgenau in einer umlaufenden Nut beidseitig fixiert. Der für die Dichtungen notwendige Anpressdruck kann dadurch erreicht werden, dass mittels Druckschrauben ein mit durchgehendem Gewinde versehener Trägerbalken gegen die Abschirmelektrode gepresst wird. Der resultierende Gegendruck kann beispielsweise von Druckaufnehmern auf die Hohlelektrode übertragen werden. Diese ihrerseits drückt den Isolator, der gleichzeitig als Dichtung wirkt, gegen den unteren Gehäuseteil.

An einem Ausführungsbeispiel wird eine erfindungsgemäße Einrichtung näher beschrieben. Die zugehörigen Zeichnungen zeigen dabei:
- Fig. 1:: Gesamtansicht einer erfindungsgemäßen Plasmaquelle im Längsschnitt
- Fig. 2: Schnittdarstellung der zugehörigen Elektrodenform inklusive Verbindungselemente
- Fig. 3: Vergleich von Teilchendichte und Entladungsstrom in Abhängigkeit von der angelegten HF-Spannung mit und ohne Magnetfeld für eine Argon-Entladung bei 1 Pa Arbeitsdruck
- Fig. 4: Schnittdarstellung erfindungsgemäßer Einrichtungen mit unterschiedlichen Varianten des Anpassnetzwerkes.

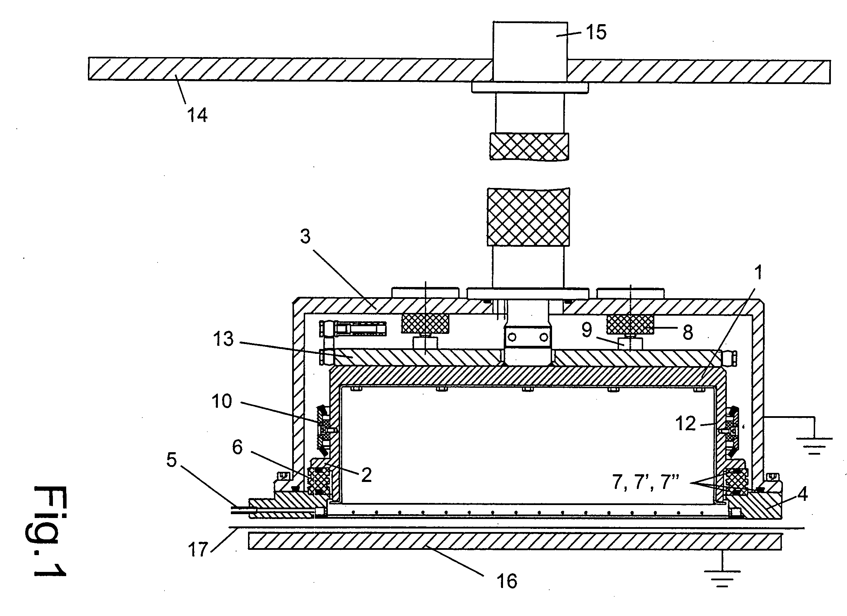

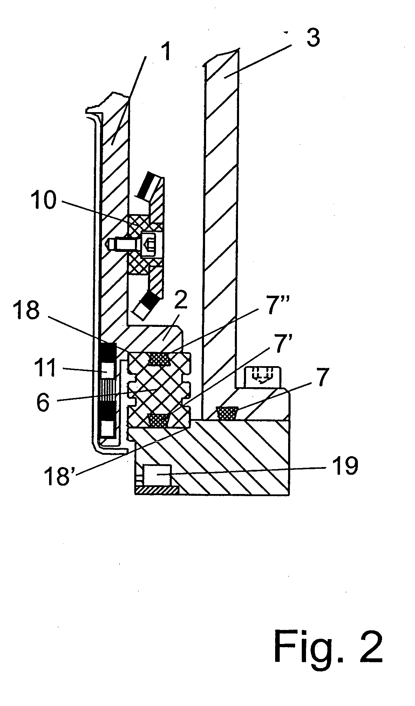

Fig. 1 zeigt einen Schnitt durch eine erfindungsgemäße Einrichtung. Eine rechteckige wannenförmige Hohlelektrode 1 von 400 mm Länge ist an ihrer Außenseite mit einem umlaufenden Rand 2 versehen. Die gesamte Hohlelektrode wird von einer Abschirmelektrode 3 umgeben, die auf ein unteres Gehäuseteil 4 aufgeschraubt ist, welches bis dicht an den unteren Rand der Hohlelektrode 1 heranreicht und diesen geringfügig überragt. Dieses untere Gehäuseteil 4 enthält ein Gaseinlasssystem 5, durch welches in unmittelbarer Nähe des unteren Randes der Hohlelektrode 1 eine gleichmäßige und fein verteilte Einleitung verschiedener Prozessgase in den von der Hohlelektrode umschlossenen Raum erfolgen kann. Das untere Gehäuseteil 4 und die Abschirmelektrode 3 sind elektrisch miteinander vakuumdicht verbunden und befinden sich auf Erdpotential. Zwischen dem umlaufenden Rand 2 an der Außenseite der Hohlelektrode 1 und dem unteren Gehäuseteil 4 ist ein Isolator 6 angeordnet, der gleichzeitig als Träger von Vakuumdichtungen 7 ausgeführt ist. Dadurch wird erreicht, dass zwischen der Hohlelektrode 1 und der Abschirmelektrode 3 ein vakuumdichter Raum entsteht. Der für die Dichtungen 7 notwendige Anpressdruck wird dadurch erreicht, dass mittels Druckschrauben ein mit durchgehendem Gewinde versehener Trägerbalken 8 gegen die Abschirmelektrode 3 gepresst wird. Der resultierende Gegendruck wird von Druckaufnehmern 9 auf die Hohlelektrode übertragen. Die Hohlelektrode 3 überträgt diesen Druck über den umlaufenden Rand 2 auf den Isolator 6. Hohlelektrode 1, Abschirmelektrode 3 und unterer Gehäuseteil 4 sind so massiv ausgeführt, dass sie im Falle der Evakuierung des Rezipienten anliegende Druckkräfte auch bei Befüllung des Zwischenraumes zwischen Hohlelektrode 1 und Abschirmelektrode 3 problemlos aufnehmen können. An der Außenseite der Hohlelektrode 1, also im Zwischenraum zwischen Hohlelektrode 1 und Abschirmelektrode 3 sind des Weiteren Anordnungen aus Permanentmagneten 10 angebracht. Diese sorgen für ein entsprechendes Magnetfeld, das im Inneren der Hohlelektrode 1 zu einer Erhöhung der Plasmadichte führt. Erfindungsgemäß ist dieses Magnetsystem 10 als geschlossener Ring von Permanentmagneten der in Fig. 2 angegebenen Polarität realisiert, die auf ein Joch aufgeklebt sind. Die absolute Ausrichtung der Magnetisierung ist nur von untergeordneter Bedeutung. Wichtig ist die relative Ausrichtung der Magnetisierung der Magneten zueinander - es muss gewährleistet sein, dass die Magnetfeldlinien geschlossen sind. Aufgrund der massiven Ausführung der Hohlelektrode 1 ist es weiterhin möglich, Magnete 11 in deren Metallkörper einzubetten, wenn dies für eine gewünschte Feldverteilung notwendig ist. Die Verwendung eines Kupfereinsatzes 12 schützt in diesem Falle einerseits dahinter befindliche Magnete 11 vor Kontaminationen. Andererseits kann im Fall von Reinigungs- und Wartungsarbeiten die Ausfallzeit der Hochfrequenz-Plasmaquelle durch einfachen Austausch des Kupfereinsatzes 12 erheblich verkürzt werden.
Auf der Rückseite der Bodenplatte der wannenförmigen Hohlelektrode ist eine Wasserkühlung 13 angeordnet. Zwischen der Rezipientenwand 14 und der Abschirmelektrode 3 ist eine gegenüber dem Vakuum abgedichtete Durchführung 15 vorgesehen, durch die die Zuleitung der einzuspeisenden elektrischen Energie über entsprechende Kabel, die Zufuhr von Arbeitsgas und Kühlwasser erfolgen kann. In einer besonderen Ausführungsform wird diese Durchführung gleichzeitig dazu benutzt, eine Verbindung zwischen dem gegenüber dem Vakuum abgedichteten Zwischenraum zwischen Hohl- und Abschirmelektrode und der die Vakuumanlage umgebenden Atmosphäre zu schaffen. Für die Durchführung kommen im Prinzip bekannte Wellrohrschläuche und Flanschelemente zum Einsatz. Unmittelbar vor der Öffnung der Hohlelektrode befindet sich eine ebene Gegenelektrode 16, die mit dem Erdpotential verbunden ist. Zwischen Gegenelektrode 16 und Hohlelektrode 1 (unmittelbar vor der Gegenelektrode 16) wird das zu beschichtende Substrat 17 stationär oder beweglich angeordnet. Auf diese Weise bildet das Substrat 17 selbst den Abschluss eines mit einem dichten Plasma erfüllten Raumes, was für eine hohe Effektivität der angestrebten Plasmabehandlung sorgt.
Die Streukapazität erfindungsgemäßer Hohlelektroden ist in jedem Fall kleiner als die der konventionellen Hohlelektroden mit gleicher Arbeitsbreite.
Der häufig geforderte Spaltabstand von maximal 10 mm kann durch die Gasbefüllung des Zwischenraumes beliebig groß gewählt werden und ist nur noch gestalterischen Beschränkungen, z. B. maximalen Außenmaßen beim Einbau in kundenspezifischen Vakuumanlagen, unterworfen. Dadurch wird die bereits erwähnte Streukapazität erheblich reduziert. Im Fall der vorliegenden Hochfrequenz-Plasmaquelle von 400 mm Breite ergibt sich bei einer durchschnittlichen Breite des in diesem Falle luftgefüllten Zwischenraumes von 20 mm bereits eine Reduktion von 160 pF auf 95 pF. Damit werden die mit der Streukapazität verbundenen Blindstromverluste um 40 % reduziert. Die mit der geometrischen Aufskalierung, also einer Verbreiterung der Elektroden für industriell übliche Bandbreiten, verbundene Erhöhung der Streukapazität wird moderat gehalten, bzw. wird es damit überhaupt erst möglich, größere Elektrodengeometrien zu realisieren.

Fig. 2 zeigt einen Ausschnitt der erfindungsgemäßen Elektrodenanordnung, dem nochmals die Realisierung des druckentkoppelten Zwischenraumes zwischen Hohl- und Abschirmelektrode zu entnehmen ist. Deutlich zu sehen sind die drei Dichtungselemente 7, die für die Vakuumdichtheit der Anordnung sorgen. Ein Dichtungselement befindet sich in einer Nut, die in eine Fläche der Abschirmelektrode 3 eingearbeitet ist, die bei der Montage auf den unteren Gehäuseteil 4 an diesen gepresst wird. Durch die Montage entstehen genügend hohe Andruckkräfte, um die Dichtwirkung zu erzielen. Zwei weitere Dichtungselemente sind in entsprechende Nuten des Isolators 6 eingearbeitet und entfalten ihre Dichtwirkung, wenn durch die Montage zwischen dem unteren Gehäuseteil und dem umlaufenden Rand 2 auf der Rückseite der Hohlelektrode 1 ausreichend hohe Andruckkräfte auf den Isolator 6 wirken. Der umlaufende Rand 2 sowie der untere Gehäuseteil 4 sind jeweils mit einer Stufe 18, 18' versehen, die ein Verrutschen des Isolators 6 durch Druckunterschiede im montierten Zustand der Anordnung verhindert. Ebenfalls dargestellt ist die Anordnung eines weiteren Magnetsystems 11, das sich an der Innenseite der Hohlelektrode 1 in deren Wand eingearbeitet befindet. Um dieses Magnetsystem 11 vor einer starken Beaufschlagung durch das Plasma zu schützen bzw. Kontaminationen zu verhindern, ist die Hohlelektrode mit einem formschlüssigen Kupfereinsatz 12 ausgekleidet. Dieser lässt sich im Falle einer erforderlichen Wartung problemlos austauschen. Im unteren Gehäuseteil 4 befindet sich weiterhin ein umlaufender Gaskanal 19 als Bestandteil des Gaseinlasssystems.

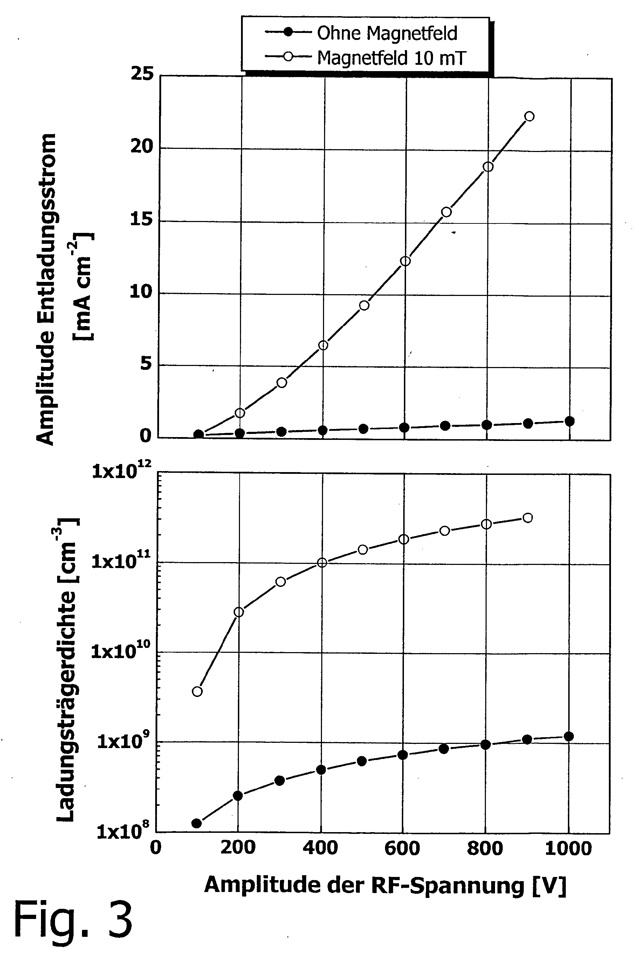

Fig. 3 verdeutlicht den Einfluss eines Magnetfeldes auf den Entladungsstrom und die erreichte Ladungsträgerdichte einer Plasmaentladung in einer erfindungsgemäßen Einrichtung. Ein magnetfeldverstärktes Hochfrequenz-Plasma hat vorteilhafte Auswirkungen auf die lonenstromdichte, welche auf die Gegenelektrode einwirkt. Bei Anwesenheit magnetischer Felder sind die Elektronen in ihrer Beweglichkeit eingeschränkt. Das hat zur Folge, dass deren Verlustrate zu benachbarten Metallflächen sinkt und eine größere Zahl von lonisationen pro Elektron möglich ist. Im Fall von durch Hochfrequenz angeregten Plasmen steigt die Ladungsträgerdichte im Plasma um mehr als 2 Größenordnungen, wie Simulationsrechnungen zeigen, und mit ihr die lonenstromdichte in der Plasmarandschicht. Das vor einer Elektrode befindliche Substratmaterial ist damit einem entsprechend verstärkten ionenbombardement ausgesetzt. Die höheren lonenstromdichten bewirken entsprechend höhere Ätzraten und damit eine höhere Produktivität des Behandlungs- oder Beschichtungsprozesses. Magnetfelderzeugende Einrichtungen können abweichend vom beschriebenen Ausführungsbeispiel außerhalb des Plasmas natürlich auch in zahlreichen anderen räumlichen Orientierungen angeordnet werden, um eine gewünschte Feldlinienverteilung und Magnetfeldstärke zu erreichen.

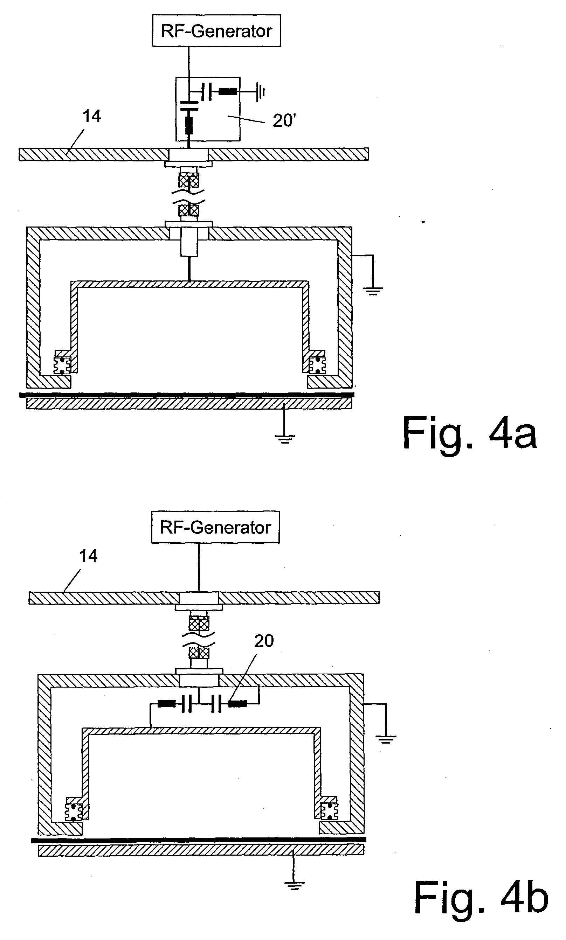

In Fig. 4 sind zwei erfindungsgemäße Anordnungen schematisch dargestellt, die das zur Energieeinspeisung unumgängliche Anpassnetzwerk 20, vorliegend aus passiven Bauelementen bestehend, zeigen. In Fig. 4a befindet sich das Anpassnetzwerk 20' außerhalb des Rezipienten, was zu einer erhöhten Verlustleistung durch größere Leitungslängen zwischen Anpassnetzwerk 20 und Einspeispunkt führt. In Fig. 4b ist das Anpassnetzwerk 20 im druckentkoppelten Zwischenraum zwischen Hohl- und Abschirmelektrode untergebracht. Auf diese Weise lässt sich eine besonders verlustarme Anordnung realisieren.

Durch einen Einbau des Anpassnetzwerkes in den druckentkoppelten Zwischenraum entfällt die bisherige Beschränkung, die Hochfrequenz-Plasmaquelle entweder in der Nähe einer Rezipientenwand anzuordnen oder hohe Verlustleistungen in Kauf zu nehmen. Besonders eignen sich für diesen Zweck dem Prozess und der Hochfrequenz-Plasmaquelle angepasste sogenannte Fixed-Match Lösungen, die aus passiven Elementen aufgebaut sind und weniger störanfällig sind als zurzeit verbreitet eingesetzte aktive Anpassnetzwerke mit regelbaren Kapazitäten. In diesem Fall kann die Zuleitung vom Hochfrequenz-Generator bis zur Hochfrequenz-Plasmaquelle mittels standardisiertem 50-Ohm Koaxialkabel erfolgen. Alternativ kann die Einkopplung der elektrischen Energie in die Hohlelektrode an mehr als einem Punkt auf der Elektrode erfolgen, um eine homogene Versorgung der Hohlelektrode bei großen Elektrodenflächen zu erreichen, wobei auch in diesem Fall eine Unterbringung des Anpassnetzwerkes im druckentkoppelten Zwischenraum zwischen Hohl- und Abschirmelektrode erfolgen kann.

## Patentansprüche

1. Einrichtung zur Erzeugung von Plasmen durch Hochfrequenzentladungen für die Plasma- und Ionenbehandlung oder zur Abscheidung von Schichten durch Plasmapolymerisation auf flache platten- oder bandförmige Materialien oder anders geformte Substrate in Vakuumanlagen mit Hilfe eines mit Hochfrequenz gespeisten Plasmas, enthaltend mindestens zwei Elektroden, zwischen denen eine Plasmaentladung unterhalten werden kann, wobei eine Elektrode als Hohlelektrode (1) ausgeführt ist, eine geerdete ebene oder gekrümmte Fläche eine Gegenelektrode (16) bildet und die der Plasmaentladung abgewandte Seite der Hohlelektrode (1) von einer Abschirmelektrode (3) umschlossen ist, **dadurch gekennzeichnet, dass** der Raum zwischen Hohlelektrode (1) und Abschirmelektrode (3) vom Vakuum druckentkoppelt ausgeführt ist und dass in diesem Raum ein gegenüber dem Vakuum erhöhter Druck eingestellt werden kann.

2. Einrichtung nach Anspruch 1, **dadurch gekennzeichnet, dass** der Raum zwischen Hohlelektrode und Abschirmelektrode vollständig gegenüber dem Vakuum abgedichtet ist.

3. Einrichtung nach Anspruch 1 oder 2, **dadurch gekennzeichnet, dass** der Raum zwischen Hohlelektrode und Abschirmelektrode mit Luft oder einem anderen Gasgemisch gefüllt ist.

4. Einrichtung nach einem der Ansprüche 1 bis 3, **dadurch gekennzeichnet, dass** im Raum zwischen Hohlelektrode und Abschirmelektrode Normaldruck herrscht.

5. Einrichtung nach einem der Ansprüche 1 bis 4, **dadurch gekennzeichnet, dass** das vorzubehandelnde oder zu beschichtende Material selbst die Gegenelektrode bildet, an der Gegenelektrode anliegt oder unmittelbar an dieser vorbeigeführt werden kann.

6. Einrichtung nach einem der Ansprüche 1 bis 5, **dadurch gekennzeichnet, dass** sich im druckentkoppelten Raum zwischen Hohlelektrode und Abschirmelektrode und/oder auf der der Plasmaentladung abgewandten Seite der Gegenelektrode magnetfelderzeugende Einrichtungen zur Erzeugung magnetischer Felder zur Verstärkung und zur Beeinflussung der Verteilung des Plasmas befinden.

7. Einrichtung nach Anspruch 6, **dadurch gekennzeichnet, dass** die magnetfelderzeugenden Einrichtungen Permanentmagneten enthalten.

8. Einrichtung nach Anspruch 6 oder 7, **dadurch gekennzeichnet, dass** die magnetfelderzeugenden Einrichtungen so dimensioniert sind, dass Flussdichten von 0 bis 50 mT erzeugt werden können.

9. Einrichtung nach einem der Ansprüche 1 bis 8, **dadurch gekennzeichnet, dass** in den druckentkoppelten Zwischenraum ein passives oder aktives Anpassnetzwerk eingebaut ist.

10. Einrichtung nach einem der Ansprüche 1 bis 9, **dadurch gekennzeichnet, dass** die Zuleitung der elektrischen Energie von einem Hochfrequenz-Generator über einen oder mehrere konventionelle Koaxialleiter erfolgt.

11. Einrichtung nach einem der Ansprüche 1 bis 10, **dadurch gekennzeichnet, dass** die Einkopplung der elektrischen Energie an mehr als einem Punkt auf der Hohlelektrode erfolgt.

12. Einrichtung nach einem der Ansprüche 1 bis 11, **dadurch gekennzeichnet, dass** die Hohlelektrode mit einer Wasserkühlung versehen ist.
